# EUROPÄISCHE PATENTANMELDUNG

(11) **EP 0 703 722 A2**
(43) Veröffentlichungstag der Anmeldung: **27.03.1996**
(21) Anmeldenummer: 95114905.3
(22) Anmeldetag: 21.09.1995
(51) Int. Cl.: H05K 7/14

(54) **Träger für einschiebbare elektrische Baugruppen**

(30) Priorität: 26.09.1994 DE 4434360
(71) Anmelder: SIEMENS AKTIENGESELLSCHAFT, D-80333 München (DE)
(72) Erfinder: Heitzig, Claus-Peter, Dipl.-Ing.(FH), D-85235 Pfaffenhofen (DE); Mair, Eduard, D-81475 München (DE); Sedlmeier, Peter, Dipl.-Ing.(FH), D-81669 München (DE)

(57) **Zusammenfassung**

Die Höhe des Baugruppenträgers ist z.B. für eine Baugruppe mit einem 11 Längeneinheiten langen Steckverbinder ausgelegt. Der Baugruppenträger ist mittels Zwischenebenen lückenlos in eine Vielzahl von unterschiedlich hohen Teilbereichen für Baugruppen mit Steckverbindern von 1, 2, 3, oder 5 Längeneinheiten langen Steckverbindern unterteilbar.

## Beschreibung

Die Erfindung bezieht sich auf einen Baugruppenträger für einschiebbare elektrische Baugruppen, wobei Steckverbinder der Baugruppen auf Steckkontakte einer Rückwandverdrahtungsplatte des Baugruppenträgers aufsteckbar sind, wobei der Baugruppenträger durch in Zwischenebenen angeordnete Führungen in Teilbereiche unterteilbar ist, in denen entsprechend niedrigere Baugruppen übereinander in den Baugruppenträger einsetzbar sind, wobei die Längen der Steckverbinder in einem ganzzahligen vielfachen einer Längeneinheit abstufbar sind und wobei für jede Zwischenebene eine Längeneinheit der Bauhöhe des Baugruppenträgers vorgesehen ist.

Ein derartiger Baugruppenträger ist z.B. in der Firmenschrift Siemens, SIPAC, Aufbausystem metrisch, Katalog ET 2, Nov. 1990 S.1/12 und 4/6 bis 4/9 bekannt geworden. Danach ist ein Baugruppenträger in seiner Höhe durch Zwischenböden unterteilbar, die in verschiedenen Höhen angebracht werden können. Eine Längeneinheit beträgt dort 25 mm und ist als System Unit (SU) bezeichnet. Steckverbinder werden von 1 bis 9 SU-Länge angeboten. Der Baugruppenträger ist so hoch ausgebildet, daß eine Baugruppe mit zwei übereinander angeordneten Steckverbindern von neun SU eingesteckt werden kann. Bei öffentlichen Vermittlungssystemen sind Baugruppenträger für Baugruppen mit neun SU-Steckverbindern üblich. Unterteilungen durch mehrere Zwischenebenen können nur in begrenzten variationsumfang durchgeführt werden. Dabei ist zu beachten, daß für die zusätzlichen Rahmenteile der Zwischenböden jeweils eine Längeneinheit (1 SU) verbraucht wird.

Ferner ist z.B. durch die DE Rittal Handbuch 27 eine Serie von Baugruppenträgern, in die jeweils Baugruppen unterschiedlicher Höhe mit dem ganzzahligen Vielfachen einer Hoheneinheit (Längeneinheit) von z.B. 1 3/4 Zoll (inch) einsteckbar sind. Derartige Höhen entsprechen z.B. dem 3-, 6-, 7- oder 9-fachen einer Höheneinheit.

Der Erfindung liegt die Aufgabe zugrunde, einen Baugruppenträger zu schaffen, der möglichst viele Kombinationsmöglichkeiten für unterschiedlich hohe Baugruppen aufweist.

Diese Aufgabe wird durch die Erfindung gemäß Anspruch 1 gelöst. Aus konstruktiver Gründen weisen die Baugruppenträger vorzugsweise Höhen auf, die dem 11- oder 23- fachen einer Längeneinheit entsprechen. In derartigen Baugruppenträgern können nun übereinander angeordnete Baugruppen in folgenden Abstufungen aufgenommen werden:
Bei einem 11 SU hohen Baugruppenträgern:
1 Baugruppe mit 11-SU-Steckverbinder,
2 Baugruppen mit 5-SU-Steckverbinder,
3 Baugruppen mit 3-SU-Steckverbinder,
4 Baugruppen mit 2-SU-Steckverbinder oder
6 Baugruppen mit 1-SU-Steckverbinder.
Bei einem 23 SU hohen Baugruppenträger:
1 Baugruppe mit 23-SU-Steckverbinder,
2 Baugruppen mit 11-SU-Steckverbinder,
3 Baugruppen mit 7-SU-Steckverbinder,
4 Baugruppen mit 5-SU-Steckverbinder,
6 Baugruppen mit 3-SU-Steckverbinder,
8 Baugruppen mit 2-SU-Steckverbinder oder
12 Baugruppen mit 1-SU-Steckverbinder.

Eine derartige Vielfalt von Unterteilungsmöglichkeiten für übereinanderliegende Baugruppen gleicher Höhe ist bei keiner anderen Bauhöhe dieses Höhenbereiches möglich. Besonders vorteilhaft ist es, daß dabei alle Höhenabschnitte mit Baugruppen oder Rahmenteilen belegt werden können, so daß kein Höhenabschnitt ungenutzt bleibt.

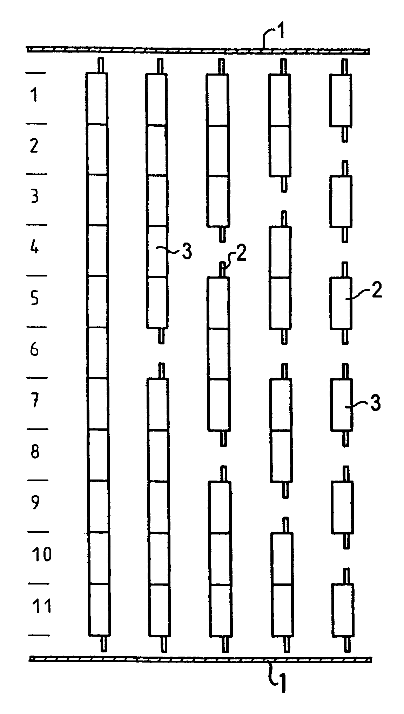

Im folgenden wird die Erfindung anhand eines in der Zeichnung dargestellten Ausführungsbeispieles näher erläutert.

Die dargestellte Figur zeigt schematisiert eine obere und eine untere Gehäusewand 1 eines Baugruppenträgers. Zwischen die beiden Gehäusewände 1 sind Baugruppen 2 von unterschiedlicher Höhe mit entsprechenden Rückwandsteckern 3 einschiebbar, wobei zwischen den übereinanderliegenden Baugruppen 2 jeweils ein nicht dargestellter Zwischenboden mit einer Höhe von 1 Längeneinheit eingesetzt ist, in dem die Baugruppen geführt sind, so daß der Abstand zwischen zwei übereinander fluchtend angeordneten Steckverbindern jeweils eine Längeneinheit beträgt. Die Steckverbinder weisen eine Länge von 1 bis 11 Längeneinheiten auf. Die Anzahl n der ohne Platzverlust übereinander einschiebbaren Baugruppen bzw der auf die Rückwandverdrahtung aufsteckbaren Steckverbinder ergibt sich in folgender Abstufung: Entsprechend ihrer Höhe können z.B. auf die Baugruppenrückwand entweder ein 11 Einheiten langer Steckverbinder oder übereinanderliegend zwei 5 Einheiten oder drei 3 Einheiten oder vier 2 Einheiten oder sechs 1 Einheit lange Steckverbinder aufgesteckt werden.

## Patentansprüche

1. Baugruppenträger für einschiebbare elektrische Baugruppen (2) wobei Steckverbinder (3) der Baugruppen (2) auf Steckkontakte einer Rückwandverdrahtungsplatte des Baugruppenträgers aufsteckbar sind, wobei der Baugruppenträger durch in Zwischenebenen angeordnete Führungen in Teilbereiche unterteilbar ist, in denen entsprechend niedrigere Baugruppen übereinander in den Baugruppenträger einsetzbar sind, wobei die Längen der Steckverbinder mit den entsprechend hohen Baugruppen in einem ganzzahligen Vielfachen einer Längeneinheit abstufbar sind und wobei für jede Zwischenebene eine Längeneinheit der Bauhöhe des Baugruppenträgers vorgesehen ist,
**dadurch gekennzeichnet,**
daß die Höhe des Baugruppenträgers auf eine Baugruppe ausgelegt ist, deren Steckverbinder eine Länge des ganzzahligen Vielfachen (n) von zwölf minus einer (12n-1) Längeneinheit aufweist.
